# EUROPÄISCHE PATENTSCHRIFT

(11) **EP 2 869 725 B1**
(45) Veröffentlichungstag und Bekanntmachung des Hinweises auf die Patenterteilung: **26.12.2018**
(21) Anmeldenummer: 13756287.2
(22) Anmeldetag: 05.07.2013
(51) Int. Cl.: B32B 15/085, A45C 11/18, H05K 9/00

(54) **SCHUTZVORRICHTUNG FÜR EINE EINEN MAGNETSTREIFEN AUFWEISENDE CHIPKARTE**
PROTECTIVE DEVICE FOR A CHIP CARD HAVING A MAGNETIC STRIP
DISPOSITIF DE PROTECTION POUR UNE CARTE À PUCE PRÉSENTANT UNE BANDE MAGNÉTIQUE

(30) Priorität: 05.07.2012 AT 502702012
(43) Veröffentlichungstag der Anmeldung: 13.05.2015
(73) Patentinhaber: Veigl, Michael Friedhelm, 3314 Strengberg (AT)
(72) Erfinder: Veigl, Michael Friedhelm, 3314 Strengberg (AT)
(74) Vertreter: Jell, Friedrich
(86) Internationale Anmeldenummer: PCT/AT2013/050133
(87) Internationale Veröffentlichungsnummer: WO 2014/005169

(56) Entgegenhaltungen:
- AT-B- 377 671
- DE-A1-102009 006 140
- JP-A- JPH03 241 529
- US-A- 4 632 250
- US-A- 5 941 375
- US-A1- 2009 067 150

## Beschreibung

### Technisches Gebiet

Die Erfindung betrifft eine Schutzvorrichtung für eine einen Magnetstreifen aufweisende Chipkarte oder Karte mit einer Aufnahme für die Chipkarte oder Karte und mit einer magnetischen und/oder elektromagnetischen Abschirmung, die wenigstens eine Schicht aus Weißblech auf mindestens zwei Breitseiten der Aufnahme aufweist.

### Stand der Technik

Um eine Chipkarte gegenüber EMV abzuschirmen, ist es aus dem Stand der Technik bekannt (DE20112311U1), eine aus einem Weißblech gefaltete Aufnahme für die Chipkarte auszubilden. Das Weißblech erstreckt sich auf beiden Breitseiten der Aufnahme und zeigt auf einer Breitseite eine mittige Ausnehmung zum Ein- und Ausschieben der Chipkarte. Nachteilig kann diese Aufnahme keine standfeste Abschirmung gegenüber einem elektrischen und/oder magnetischen Feld, insbesondere gegenüber NFC bzw. RFID oder auch nahen statischen Magnetfeldern, wie diese beispielsweise von Lautsprechern in Mobiltelefonen bekannt sind, gewährleisten.

Die Dokumente US4632250A, US2009/067150A1, US5941375A offenbaren mehrschichtige Schutzhüllen nach dem vorliegendem Zusammenhang.

### Darstellung der Erfindung

Die Erfindung hat sich daher die Aufgabe gestellt, ausgehend vom eingangs geschilderten Stand der Technik eine Schutzvorrichtung zu schaffen, die eine Abschirmung einer aufgenommenen Chipkarte sicherstellen kann und in ihrer Herstellung zudem kostengünstig ist.

Die Erfindung löst die gestellte Aufgabe durch die Merkmale des Anspruchs 1.

Bildet die Weißblechschicht auf beiden Breitseiten der Aufnahme eine wenigstens den Magnetstreifen unterbrechungsfrei abdeckende Abschirmung aus, kann im Gegensatz zu einer aus einem Weißblech gefalteten Aufnahme vermieden werden, dass sich an Stoßkanten des Weißblechs unkontrolliert elektrische und/oder magnetische Felder ausbilden, die zu Beschädigungen der Funktion der Chipkarte führen können. Durch diese spaltfreie Abschirmung in dem abzuschirmenden Kartenbereich, wie Magnetstreifen, Chip und/oder dergleichen, kann daher dieser besonders gut geschützt werden. Außerdem können bei einer unterbrechungsfreien Weißblechschicht magnetische Sättigungseffekte klein gehalten werden, sodass selbst vergleichsweise hohe magnetische Flussdichten statischer Magnetfelder zuverlässig abgeschirmt werden können. Zudem kann eine mithilfe der Erfindung geschützte Chipkarte auch vor einer NFC bzw. RFID Abfrage sicher abgeschirmt werden, weil sich deren magnetische Wechselfelder bzw. hochfrequente Radiowellen nicht mit der Chipkarte koppeln können. Die erfindungsgemäße Schutzvorrichtung kann jedoch nicht nur eine äußerst sichere Abschirmung gegenüber elektrischen und/oder magnetischen Feldern gewährleisten, sie ist aufgrund einer Verwendung von unterbrechungsfreiem Weißblech auch vergleichsweise kostengünstig in ihrer Herstellung. Zudem kann Weißblech gegenüber hoch permeablen Werkstoffen ein deutlich besseres Verhalten bei Erreichen der magnetischen Sättigung zeigen. So ist nämlich die Hysteresekurve für viele hoch permeable Werkstoffe im Bereich der Sättigung wesentlich flacher als die von Weißblech. Dadurch kann bei hoch permeablen Werkstoffen ab ihrer Sättigung so gut wie kein zusätzlicher magnetischer Fluss durch die Abschirmung erfolgen, wodurch die zu schützende Karte wäre besonders stark gefährdet ist. Bei Verwendung von Weißblech kann aufgrund der steileren Hysteresekurve zumindest ein Teil des zusätzlichen magnetischen Flusses über das Weißblech abgeleitet werden.

Weist die Abschirmung wenigstens drei Schichten auf, die aus der Weißblechschicht, einer weiteren weichmagnetischen Werkstoffschicht und einer elektrisch isolierenden Trennschicht bestehen, wobei die Trennschicht zwischen der Weißblechschicht und der weichmagnetischen Werkstoffschicht liegt, kann eine besonders hochwertige Abschirmung von statischen Magnetfeldern geschaffen werden. Eine weichmagnetische Werkstoffschicht kann nämlich nur eine materialabhängig begrenzte Flussdichte aufnehmen, bevor der Werkstoff in Sättigung geht und den magnetischen Fluss durchtreten lässt. Im Falle einer ersten weichmagnetischen Werkstoffschicht und einer zweiten weichmagnetischen Werkstoffschicht, die voneinander durch eine Trennschicht auf Abstand gehalten werden, kann das durchtretende statische Magnetfeld durch die erste sich in Sättigung befindliche Werkstoffschicht der zweiten weichmagnetischen Werkstoffschicht breiter aufgefächert zugeführt werden. Dies kann zur Folge haben, dass sich keine punktuellen Feldüberbelastungen an der zweiten weichmagnetischen Werkstoffschicht ausbilden können, sodass ein Durchtreten des Felds durch die Abschirmung vermieden werden kann. Im Gegensatz zum Stand der Technik kann damit selbst starken elektrischen und/oder magnetischen Feldern standgehalten und so die Chipkarte besonders gut geschützt werden.

Vorteilhaft hat sich zur Beabstandung der weichmagnetischen Werkstoffschichten eine elektrisch isolierende Trennschicht herausgestellt, die aus Polypropylen besteht.

Eine besonders standfeste Abschirmung kann ausgebildet werden, wenn die äußere weichmagnetische Werkstoffschicht gegenüber der inneren Weißblechschicht eine höhere Sättigungsmagnetisierung aufweist.

Hohe Sättigungsgrenzen bei statischer Magnetfeldbelastung der Abschirmung können gewährleistet werden, wenn ein Dynamoblech die weichmagnetische Werkstoffschicht ausbildet. Ein besonders hoher Schutz einer einen Magnetstreifen aufweisenden Chipkarte oder Karte kann damit gewährleistet werden.

Bildet das Weißblech die weichmagnetische Werkstoffschicht aus, können die Herstellkosten der Schutzvorrichtung noch weiter reduziert werden.

Konstruktive Einfachheit und dennoch ausreichende Abschirmung können erreicht werden, wenn das gegenüber der Chipkarte äußere Weißblech eine Mindestdicke von 0,3 mm und das innere Weißblech eine Mindestdicke von 0,15 mm aufweisen. Eine ausreichende Beabstandung der weichmagnetischen Werkstoffschichten kann erreicht werden, indem die Mindestdicke der Trennschicht 0,3 mm beträgt.

Die Aufnahme endet in einem sich erweiternden Öffnungsmund, der sich durch die in diesem Bereich aufgebogene Abschirmung ausbildet, so dass die Chipkarte durch die erweiterte Öffnung leichter in die Schutzvorrichtung eingesetzt werden kann. Dennoch kann ein sicherer Halt der Chipkarte aufgrund der fester sitzenden Aufnahme in der vom Öffnungsmund abgewandten Seite der Schutzvorrichtung erhalten bleiben. Eine einfach zu fertigende Ausführung der Schutzvorrichtung kann entstehen, wenn auf beiden Breitseiten der Aufnahme die Weißblechschicht vollflächig vorgesehen ist.

Als besonders handhabungsfreundlich kann sich die Schutzvorrichtung herausstellen, wenn ihre Aufnahme eine mittige, längliche Öffnung zum Greifen der eingesetzten Chipkarte aufweist. Außerdem kann damit vermieden werden, dass im Vergleich zu außermittigen Greiföffnungen der Magnetstreifen bzw. Teile des Magnetstreifens freiliegen und so durch elektrische und/oder magnetische Felder beschädigt werden können.

Die Abschirmung ist in einer Kunststoffhülle eingebettet, so dass eine direkte Berührung der Abschirmung mit der Chipkarte vermieden wird. Dies kann unter anderem die Gefahr der Beschädigung der Chipkarte durch die Weißblechschicht vermindern.

Die Schutzhülle weist entlang des Rands der Abschirmung eine Schweißnaht auf.

Dadurch ist an der Schutzhülle keinerlei Werkstoff der Abschirmung frei zugänglich, wodurch eventuelle Verletzungen vermieden werden können. Außerdem zeigen sich auch hier durch die Wahl einer Weißblechschicht als Abschirmung Vorteile hinsichtlich einer einfachen Verarbeitung. Die magnetischen Eigenschaften von Mu-Metallen können zum Beispiel beim Ablängen an den Schnittkanten stark verändert werden - nachteilig muss, um diesen Vorgang rückgängig zu machen, das Mu-Metall darauf weichgeglüht werden, was bei einer Einbettung in Kunststoffhüllen klarerweise nicht möglich ist. Auch können versehentliche Berührungen mit der Schweißelektrode während des Einschweißvorgangs die magnetischen Eigenschaften der Mu-Metalle beeinflussen. Weißblech hingegen ist gegen solche Verarbeitungsschritte weitgehend unempfindlich.

### Kurze Beschreibung der Zeichnung

In den Figuren ist beispielsweise der Erfindungsgegenstand anhand einer Ausführungsvariante näher dargestellt. Es zeigen
- Fig. 1: eine teilweise aufgerissene Draufsicht auf eine Schutzvorrichtung mit eingeschobener Chipkarte nach einem ersten Ausführungsbeispiel und
- Fig. 2: eine Schnittansicht nach II-II der Fig. 1,
- Fig. 3: eine abgerissene Seitenansicht der Schutzvorrichtung nach Fig. 1,

### Weg zur Ausführung der Erfindung

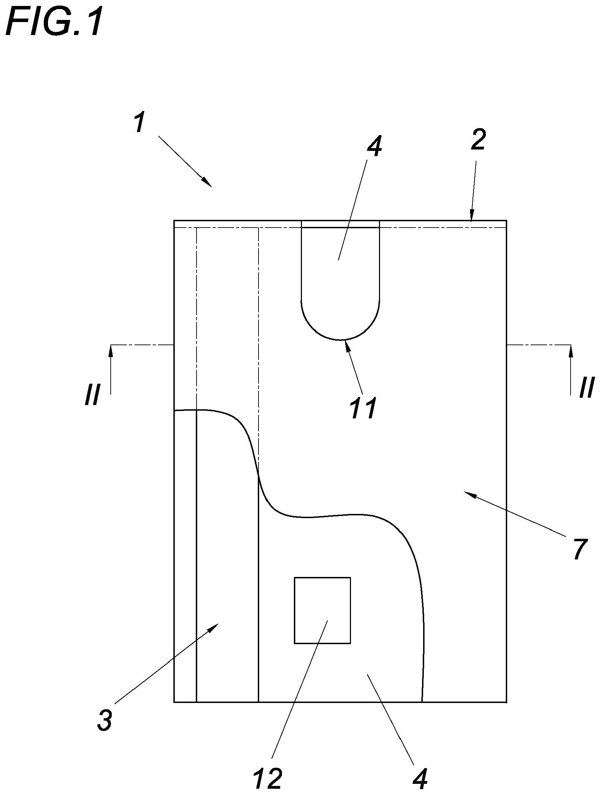

Die beispielsweise nach Fig. 1 dargestellte Schutzvorrichtung 1 bildet eine Aufnahme 2 für eine Chipkarte 4 aus, die einen Magnetstreifen 3 und Chipkontakte 12 aufweist. Die Chipkarte 4 kann in die Aufnahme 2 eingeschoben werden. Die Schutzvorrichtung 1 weist weiter eine Abschirmung 5 auf, um die in die Aufnahme 2 eingeschobene Chipkarte 4 gegenüber magnetischen und/oder elektromagnetischen Wellen abzuschirmen. Diese Abschirmung 5 wird unter anderem durch ein Weißblech 6 auf beiden Breitseiten 7 der Aufnahme 2 gebildet. Um nun eine besonders standfeste und sichere Abschirmung 5 der eingesetzten Chipkarte 4 zu erreichen, ist die Weißblechschicht 6 auf beiden Breitseiten 7 der Aufnahme 2 unterbrechungsfrei und damit vollflächig ausgeführt und bildet eine den abzuschirmenden Kartenbereich, wie beispielsweise Chip und/oder Magnetstreifen 3, abdeckende Abschirmung 5 aus. Die Weißblechschicht 6 bildet somit auf beiden Breitseiten 7 der Aufnahme 2 eine mindestens den Magnetstreifen 3 unterbrechungsfrei abdeckende Abschirmung 5 aus, indem dort diese Weißblechschicht 6 einstückig vorgesehen ist - und im Gegensatz zum Stand der Technik dort keine Faltkanten bzw. Stoßkanten ausbildet. Dadurch können Streufelder an Kanten der Weißblechschicht 6 vermieden und unter anderem ein besonders sicher abschirmender faradayscher Käfig geschaffen werden. Eine sich in der Aufnahme 2 befindliche Chipkarte 4 wird daher besonders gut geschützt.

Die Schutzvorrichtung ist als Kartenhülle ausgebildet. Weiter wird im Allgemeinen erwähnt, dass die Chipkarte 4 als EC-Karte, Kreditkarte etc. ausgebildet sein kann.

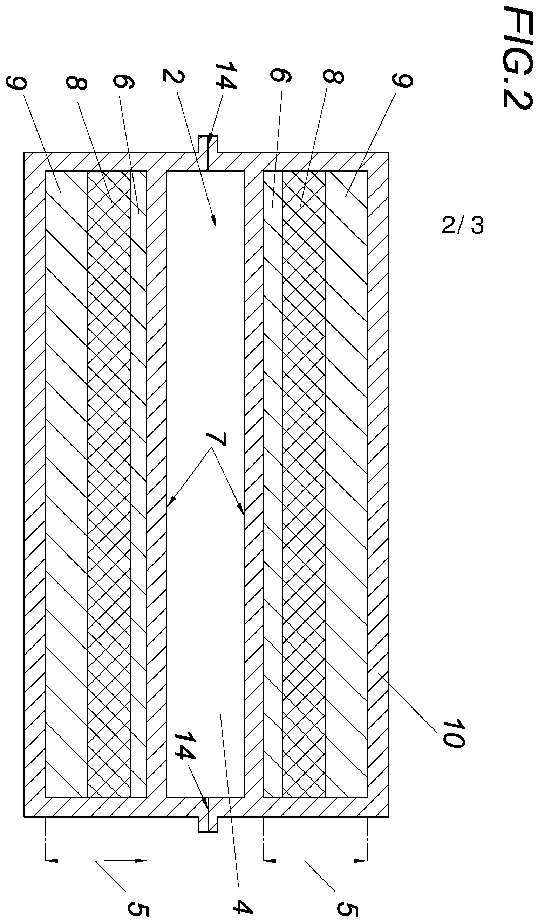

Wie insbesondere der Fig. 2 entnommen werden kann, weist die Abschirmung 5 drei Schichten 6, 8 und 9 auf. Davon ist die Weißblechsicht 6 gegenüber den anderen Schichten 8, 9 zur Chipkarte 4 innenliegend vorgesehen. Weiter ist eine weichmagnetische Werkstoffschicht 9 vorgesehen, die mit einer elektrisch isolierenden Trennschicht 8 aus Polypropylen von der Weißblechsicht 6 auf Abstand gehalten wird. Dieser Abstand ist vorteilhaft mindestens 0,3 mm, vorzugsweise 0,3 mm, welcher Abstand sich durch die Mindestdicke der Trennschicht 8 ergibt.

Als weichmagnetische Werkstoffschicht 9 wird ebenso ein Weißblech verwendet, was die Herstellkosten beträchtlich senken kann. Alternativ ist jedoch vorstellbar, dass die gegenüber der Chipkarte 4 außen liegende weichmagnetische Werkstoffschicht 9 gegenüber der innenliegenden Weißblechschicht 6 eine höhere Sättigungsmagnetisierung aufweist. Beispielsweise, indem ein Dynamoblech diese weichmagnetische Werkstoffschicht 9 ausbildet.

Bei der nach Fig. 2 dargestellten Schutzvorrichtung 1 weist das gegenüber der Chipkarte 4 äußere Weißblech 9 eine Mindestdicke von 0,3 mm, vorzugsweise 0,3 mm, und das innere Weißblech 6 eine Mindestdicke von 0,15 mm, vorzugsweise 0,15 mm, auf.

Außerdem ist die Abschirmung 5 in einer Kunststoffhülle 10 eingebettet, um die Chipkarte 4 zu schützen. Diese Kunststoffhülle 10 weist auch eine entlang des Rands der Abschirmung 5 verlaufende Schweißnaht 14 auf, um damit eine geschlossene Kunststoffhülle 10 aus Kunststofffolien ausbilden zu können.

Die Aufnahme 2 weist eine mittige Öffnung 11 zum Greifen der eingesetzten Chipkarte 4 auf. Diese mittige Öffnung 11 zeigt außerdem einem Benutzer auf einfache Weisen an, ob die Chipkarte 4 falsch eingesetzt worden ist, indem die Chipkontakte 12 durch die auf beiden Breitseiten 7 vorgesehene Öffnung 11 sichtbar ist.

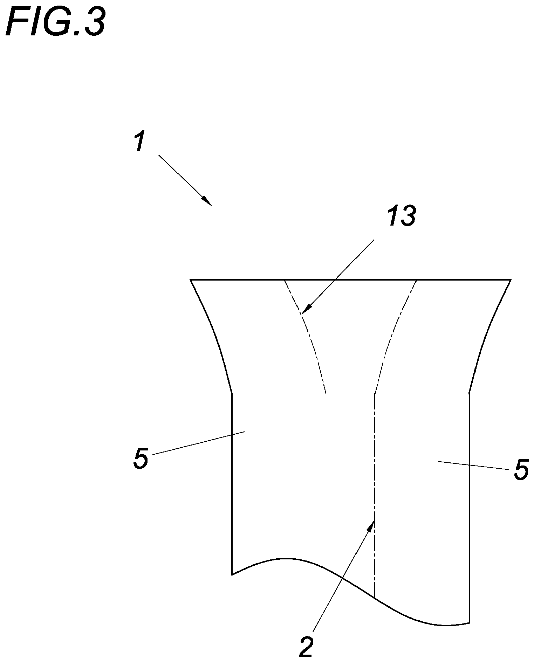

Zudem kann nach Fig. 3 erkannt werden, dass die Aufnahme 2 in einen sich erweiternden Öffnungsmund 13 endet, um damit die Chipkarte 4 erleichtert in die Aufnahme einschieben zu können. Dieser sich erweiternde Öffnungsmund 13 wird durch die in diesem Bereich aufgebogene Abschirmung 5 ausbildet, was durch die Verwendung einer Weißblechschicht 6 eine besondere Formstabilität erreicht.

## Patentansprüche

1. Schutzhülle für eine einen Magnetstreifen (3) aufweisende Chipkarte (4) oder Karte mit einer Aufnahme (2) für die Chipkarte (4) oder Karte, in welche Aufnahme (2) die Chipkarte (4) oder Karte einschiebbar ist, und mit einer magnetischen und/oder elektromagnetischen Abschirmung (5), die wenigstens eine Schicht (6) aus Weißblech auf mindestens zwei Breitseiten (7) der Aufnahme (2) aufweist, wobei die Weißblechschicht (6) auf mindestens einer Breitseite (7) der Aufnahme (2) unterbrechungsfrei und vollflächig vorgesehen ist, **dadurch gekennzeichnet, dass** die Weißblechschicht (6) auf beiden Breitseiten (7) der Aufnahme (2) unterbrechungsfrei und vollflächig vorgesehen ist, um eine wenigstens den Magnetstreifen (3) unterbrechungsfrei abdeckende Abschirmung (5) auszubilden, und dass die Schutzhülle (1) eine Kunststoffhülle (10) aufweist, wobei die Abschirmung (5) in der Kunststoffhülle (10) eingebettet ist, die entlang des Rands der Abschirmung (5) eine Schweißnaht (14) aufweist, wobei die Aufnahme (2) in einem sich erweiternden Öffnungsmund (13) endet, der sich durch die in diesem Bereich aufgebogene Abschirmung (5) ausbildet.

2. Schutzhülle nach Anspruch 1, **dadurch gekennzeichnet, dass** die Abschirmung (5) wenigstens drei Schichten aufweist, die aus der Weißblechschicht (6), einer weichmagnetischen Werkstoffschicht (9) und einer elektrisch isolierenden Trennschicht (8) bestehen, wobei die Trennschicht (8) zwischen der Weißblechschicht (6) und der weichmagnetischen Werkstoffschicht (9) liegt.

3. Schutzhülle nach Anspruch 2, **dadurch gekennzeichnet, dass** die elektrisch isolierende Trennschicht (8) aus Polypropylen besteht.

4. Schutzhülle nach Anspruch 2 oder 3, **dadurch gekennzeichnet, dass** die äußere weichmagnetische Werkstoffschicht (9) gegenüber der inneren Weißblechschicht (6) eine höhere Sättigungsmagnetisierung aufweist.

5. Schutzhülle nach Anspruch 4, **dadurch gekennzeichnet, dass** ein Dynamoblech die weichmagnetische Werkstoffschicht (9) ausbildet.

6. Schutzhülle nach Anspruch 2 oder 3, **dadurch gekennzeichnet, dass** Weißblech die weichmagnetische Werkstoffschicht (9) ausbildet.

7. Schutzhülle nach Anspruch 6, **dadurch gekennzeichnet, dass** das gegenüber der Chipkarte (4) äußere Weißblech (8) eine Mindestdicke von 0,3 mm und das innere Weißblech (6) eine Mindestdicke von 0,15 mm aufweisen.

8. Schutzhülle nach einem der Ansprüche 2 bis 7, **dadurch gekennzeichnet, dass** die Mindestdicke der Trennschicht (8) 0,3 mm beträgt.

9. Schutzhülle nach einem der Ansprüche 1 bis 8, **dadurch gekennzeichnet, dass** die Aufnahme (2) eine mittige, längliche Öffnung (11) zum Greifen der eingesetzten Chipkarte (4) aufweist.

## Claims

1. Protective cover for a chip card (4) or card having a magnetic strip (3), or card with an receptacle (2) for the chip card (4) or card, into which receptacle (2) the chip card (4) or card can be inserted, and having a magnetic and/or electromagnetic shielding (5), which has at least one layer (6) of tinplate on at least two broadsides (7) of the receptacle (2), the tinplate layer (6) being provided on at least one broadside (7) of the receptacle (2) uninterruptedly and over its entire surface, **characterized in that** the tinplate layer (6) is provided on both wide sides (7) of the receptacle (2) without interruption and over its entire surface in order to form a shield (5) covering at least the magnetic strip (3) without interruption and **in that** the protective sheath (1) has a plastic sheath (10), the shield (5) being embedded in the plastic sheath (10), which has a weld seam (14) along the edge of the shield (5), wherein the receptacle (2) ending in a widening opening mouth (13) which is formed by the shielding (5) bent up in this region.

2. Protective cover according to claim 1, **characterized in that** the shield (5) has at least three layers which consist of the tinplate layer (6), a soft-magnetic material layer (9) and an electrically insulating separating layer (8), the separating layer (8) lying between the tinplate layer (6) and the soft-magnetic material layer (9).

3. Protective cover according to claim 2, **characterized in that** the electrically insulating separating layer (8) consists of polypropylene.

4. Protective cover according to claim 2 or 3, **characterized in that** the outer soft magnetic material layer (9) has a higher saturation magnetization than the inner tinplate layer (6).

5. Protective cover according to claim 4, **characterized in that** a dynamo sheet forms the soft magnetic material layer (9).

6. Protective cover according to claim 2 or 3, **characterized in that** tinplate forms the soft magnetic material layer (9).

7. Protective cover according to claim 6, **characterized in that** the tinplate (8) outer in relation to the chip card (4) has a minimum thickness of 0.3 mm and the inner tinplate (6) has a minimum thickness of 0.15 mm.

8. Protective cover according to one of claims 2 to 7, **characterized in that** the minimum thickness of the separating layer (8) is 0.3 mm.

9. Protective cover according to one of claims 1 to 8, **characterized in that** the receptacle (2) has a central, elongated opening (11) for gripping the inserted chip card (4).

## Revendications

1. Housse de protection pour une carte à puce (4) ou une carte comportant une bande magnétique (3), ou une carte comportant un logement (2) pour la carte à puce (4) ou la carte, dans lequel le logement (2) peut recevoir la carte à puce (4) ou la carte, et comportant un blindage magnétique et/ou électromagnétique (5), qui présente au moins une couche (6) de fer blanc sur au moins deux faces larges (7) du récipient (2), la couche (6) de fer blanc étant prévue sur au moins une face large (7) du récipient (2) sans interruption et sur toute sa surface, **caractérisé en ce que** la couche de fer blanc (6) est prévue des deux côtés larges (7) du réceptacle (2) sans interruption et sur toute sa surface afin de former un écran (5) recouvrant au moins la bande magnétique (3) sans interruption et **en ce que** la gaine de protection (1) comporte une gaine plastique (10), le blindage (5) étant noyé dans la gaine en matière plastique (10) qui présente une soudure (14) le long du bord du blindage (5), le réceptacle (2) se terminant par une ouverture (13) s'élargissant qui est formée par le blindage (5) plié vers le haut dans cette région.

2. Housse de protection selon la revendication 1, **caractérisé en ce que** le blindage (5) présente au moins trois couches constituées de la couche de fer blanc (6), d'une couche de matériau magnétique doux (9) et d'une couche de séparation électriquement isolante (8), la couche de séparation (8) étant située entre la couche de fer blanc (6) et la couche de matériau magnétique doux (9).

3. Housse de protection selon la revendication 2, **caractérisée en ce que** la couche de séparation électriquement isolante (8) est constituée de polypropylène.

4. Housse de protection selon la revendication 2 ou 3, **caractérisé en ce que** la couche extérieure de matériau magnétique doux (9) présente une magnétisation de saturation plus élevée que la couche de fer blanc (6) interne.

5. Housse de protection selon la revendication 4, **caractérisé en ce qu'**une feuille de dynamo forme la couche de matériau magnétique doux (9).

6. Housse de protection selon la revendication 2 ou 3, **caractérisé en ce que** du fer-blanc forme la couche de matériau magnétique doux (9).

7. Housse de protection selon la revendication 6, **caractérisé en ce que** le fer blanc (8) extérieur par rapport à la carte à puce (4) a une épaisseur minimale de 0,3 mm et le fer blanc intérieur (6) a une épaisseur minimale de 0,15 mm.

8. Housse de protection selon l'une des revendications 2 à 7, **caractérisée en ce que** l'épaisseur minimale de la couche de séparation (8) est de 0,3 mm.

9. Housse de protection selon l'une des revendications 1 à 8, **caractérisé en ce que** le réceptacle (2) présente une ouverture centrale allongée (11) pour saisir la carte à puce (4) introduite.
